(19) **Europäisches Patentamt / European Patent Office / Office européen des brevets**

(11) **EP 1 591 995 B1**

(12) **EUROPEAN PATENT SPECIFICATION**

(45) Date of publication and mention
of the grant of the patent:
**19.06.2019  Bulletin 2019/25**

(51) Int Cl.:
***G10K 11/178*** (2006.01)   ***H03H 21/00*** (2006.01)

(21) Application number: **04010231.1**

(22) Date of filing: **29.04.2004**

(54) **Indoor communication system for a vehicular cabin**

Innenraum-Nachrichtübertragungssystem für eine Fahrzeugkabine

Système de communication d'intérieur pour une cabine de véhicule

(84) Designated Contracting States:
**AT BE BG CH CY CZ DE DK EE ES FI FR GB GR
HU IE IT LI LU MC NL PL PT RO SE SI SK TR**

(43) Date of publication of application:
**02.11.2005  Bulletin 2005/44**

(73) Proprietor: **Harman Becker Automotive Systems
GmbH
76307 Karlsbad (DE)**

(72) Inventors:
• **Haulick, Tim
89143 Blaubeuren (DE)**

• **Schmidt, Gerhard Uwe
89081 Ulm (DE)**

(74) Representative: **Grünecker Patent- und
Rechtsanwälte
PartG mbB
Leopoldstraße 4
80802 München (DE)**

(56) References cited:
**EP-A- 0 898 364      EP-A2- 1 077 584
WO-A2-03/010996      JP-A- 1992 047 787
JP-A- 2050 090 856      US-A- 4 739 513
US-A- 5 170 433      US-A- 5 386 478
US-B1- 6 674 865**

**Description**

The invention is directed to an indoor communication system for a vehicular cabin and to a method for automatically determining an equalizing filter characteristic for an indoor communication system of a vehicular cabin.

In many different circumstances, a noisy environment can render communication between different persons very difficult or almost impossible, particularly if the noise is at a similar loudness level as the speech. As a particular example, a strong background noise is present in a vehicular cabin (such as the passenger compartment of a car) due to engine and wind noise. Further possible noise sources that can deteriorate the mutual understanding of the people are the loudspeakers of a car radio or a handsfree telephone system. Due to the multitude of different noise sources, a communication both between the front seat and back seat passengers and between the driver and the front seat passenger, for example, is very difficult, in particular when the vehicle is moving at a high speed.

US 4 739 513 A discloses an apparatus for measuring and correcting characteristics in sound fields. In particular, a sound field output by an audio system of a vehicle is optimized for a listener. EP 0 898 364 A discloses systems and methods for measuring and correcting acoustic characteristics in sound fields. In US 5 386 478 A a system and a method to reduce noise inside a motor car passenger compartment is described. US 5 170 433 A teaches provision of a microphone array in a vehicle cabin and beamforming of the microphones. US 6 674 865 B1 discloses an automatic gain control for a cabin communication system for improving clarity of a voice spoken within a movable interior cabin having ambient noise includes a microphone for receiving the spoken voice and the ambient noise and for converting the spoken voice and the ambient noise into a first audio signal having a first component corresponding to the spoken voice and a second component corresponding to the ambient noise. EP 1 077 584 A2 discloses a signal loss compensation method that determines the acoustic signal transmission path between a pair of spaced intercom points within an automobile passenger compartment, for providing a transmission function parameter, which is used for controlling the acoustic signal level at a given position of the acoustic signal path. WO 03/010996 A2 discloses a sound reinforcement system comprising an equalizing means, an adaptive echo cancelling filter and a beamformer wherein a noise signal is used for estimating a transfer function. JP 2050 090856 A teaches the determination of a transfer function of an indoor communication system based on a test signal and various combinations of loudspeakers and microphones. JP 1992 047787 A teaches a sound field control system comprising means for measuring a transfer function and adapted to reduce howling effects.

In the prior art, an indoor communication system for cars has been proposed to improve communication between people located in a passenger compartment. According to this prior art system, one microphone is associated with each passenger seat, including the driver's seat. This means that in the vicinity of each seat or in the vicinity of a passenger's head sitting on a seat, a microphone is arranged. Each microphone records the speech of the respective passenger and the corresponding signals are output via loudspeakers in the car. Usually, the loudspeakers already present in the car can be associated to the different passenger seats. For example, if a loudspeaker is mounted in each door, the respective loudspeaker can be associated to the person sitting next to it. This allows for outputting the speech signals mainly at loudspeakers corresponding to passengers other than the current speaker. For example, if the driver is speaking, the corresponding speech signal may be output at the different loudspeakers except the for the driver's loudspeaker(s).

These prior art indoor communication systems, however, have the drawback that, particularly at higher amplification levels, undesirable feedback effects may occur. In principle, this drawback could be overcome by setting the stability limit (i.e., the maximal admissible amplification) in a very conservative way by the manufacturer. In other words, the maximal amplification limit can be set to such a value that under almost all circumstances, no undesired feedback effect will occur. This has the consequence, however, that in most cases, an optimal (higher) amplification that might sometimes be necessary will not be achieved.

In view of this, it is the object of the invention to provide a method for operating an indoor communication system, in particular, a method for automatically determining a possible feedback frequency of an indoor communication system, and an indoor communication system for a vehicular cabin.

This object is solved by a method for automatically determining an equalizing filter characteristic for an indoor communication system of a vehicular cabin according to claim 1 and by an indoor communication system for a vehicular cabin according to claim 12.

The invention provides a method for automatically determining an equalizing filter characteristic for an indoor communication system of a vehicular cabin, the indoor communication system comprising at least one loudspeaker and at least one microphone array connected to a beamformer, the at least one loudspeaker associated with the at least one microphone array and a corresponding speaker position, comprising the steps of:

a) emitting a predetermined test signal a loudspeaker, in particular, by one loudspeaker, of the indoor communication system,

b) receiving the test signal by a microphone array of the indoor communication system and beamforming the signals emanating from the microphone array using the beamformer connected thereto to obtain a received test signal,

c) automatically determining a transfer function in the frequency domain based on the test signal and the received test signal,

d) automatically determining an equalizing filter characteristic based on determining an extremum, in particular, a maximum, of the magnitude of the transfer function; and

e) automatically determining a maximum amplification value as $Gain_{max} = 1/\max\{|H(e^{j\Omega})G(e^{j\Omega})|\}$.

with $H(e^{j\Omega})$ being the transfer function and $G(e^{j\Omega})$ being the frequency response of the equalizing filter.

A frequency for which the transfer function has a (global or local) maximum is considered as possible feedback frequency.

Here and in the following, the term "microphone" (if not explicitly used in the context of microphone arrays) is used to denote a single microphone or, in other words, a microphone not being part of a microphone array. A loudspeaker may comprise several components such as a high-frequency and a low-frequency unit.

A transfer function is a function characterizing the transmission properties of a transmission path. These transmission properties can result from the geometry of the room where the test signal is transmitted from one or several loudspeakers to one or several microphones and/or microphone arrays and possible objects located therein. Furthermore, the transmission properties can also be influenced by electronic components along the signal path, e.g., between the signal generator and the loudspeaker. The received signal is a function, namely the transfer function, of the original test signal. The test signal is a signal as generated by a signal generator.

A beamformer processes signals emanating from a microphone array to obtain a combined signal. In its simplest form (delay-and-sum beamformer), beamforming comprises delay compensation and summing of the signals. Beamforming allows providing a specific directivity pattern for a microphone array. Thus, according to the method of the invention, a test signal is used to determine the transmission properties of the signal path as a function in the frequency domain. Based on these transmission properties, an equalizing filter characteristic is determined. Hence, in contrast to prior art indoor communication systems, this method allows for the detection of possible feedback frequencies via the transfer function that can be used for an appropriate modification of a signal to be output in order to reduce the occurrence of feedback effects.

The indoor communication system for which this method is used can comprise one or several (single) microphones and/or one or several microphone arrays. Such a microphone or microphone array can be associated to a potential speaker (passenger) and be mounted at appropriate positions. Furthermore, the indoor communication system can also comprise one or several loudspeakers associated with a microphone or microphone array and the corresponding speaker position.

In particular, in step a), the predetermined test signal can be emitted by (exactly) one loudspeaker. In this way, in particular, for each loudspeaker/microphone pair or each loudspeaker/microphone array pair, a transfer function is obtained and a corresponding equalizing filter characteristic can be determined such that for each pair, an appropriate equalizing filter is provided. In step a), the test signal can be received simultaneously by each microphone or microphone array. This allows to determine in parallel an equalizing filter characteristic for each of these microphones or microphone arrays with respect to a given loudspeaker.

Step a) can comprise emitting binary white noise or colored noise, particularly pink noise. In white noise, all frequencies (in the present context, usually, only frequencies within the range of human hearing are considered) are present and uniformly distributed. This enables a comparison of original test signal and received test signal in a very simple way. A more pleasing sound for people being present in the vehicular cabin is obtained using colored noise, particularly pink noise. Pink noise can be obtained by filtering white noise to reduce the volume at each octave.

Step c) can comprise processing the test signal and the received test signal in the time domain, in particular, using an adaptive filter or using an estimation method based on a periodogram, an autocorrelation function or cross-correlation function. Processing in the time domain is particularly useful when using broadband test signals. For example, an NLMS (normalized least means squared) algorithm (as described, e.g., in S. Haykin, B. Widrow, Least-Mean-Square Adaptive Filtering, John Wiley and Sons, 2003) can be used After processing in the time domain, the impulse response is to be transformed into the frequency domain so as to obtain the transfer function.

As an alternative to using broadband test signals, step a) can comprise emitting band pass noise with variable center frequency. In this case, however, all frequency ranges should be activated.

When emitting band pass noise, step c) can comprise determining the square root of the quotient of the short time power spectrum of the received test signal and the short time power spectrum of the test signal for each band pass noise. The transfer function can also be obtained in this way.

Step d) can comprise determining a global extremum of the magnitude of the transfer function. In particular, the global maximum with respect to the overall frequency range to be considered has a high probability of constituting a feedback frequency.

Step d) can further comprise determining a local extremum for which the magnitude of the transfer function differs not more than a predetermined amount from the magnitude of the transfer function at a global extremum. Particularly in the case of local maxima, other frequencies (in addition to the global maximum) are also considered as possible feedback frequencies.

Step d) can further comprise providing an attenuation of a predetermined frequency band of a signal being centered at a determined maximum and/or providing an amplification of a predetermined frequency band being centered at a determined minimum.

This yields a particularly advantageous equalizing. Due to such an attenuation of a signal to be output by a loudspeaker, the (broadband) stability limit can be improved by the value corresponding to the applied attenuation. Particularly if a small attenuation bandwidth is chosen, the acoustic impression of an audio signal in the vehicular cabin will hardly differ.

The attenuating step can be performed using a nonlinear phase filter. This has the advantage that inserting small delay time differences when reproducing mono signals can improve the subjective quality impression of the signal.

The invention also provides a method for automatically determining a maximum amplification value of an indoor communication system of a vehicular cabin, comprising the steps of:

automatically determining an equalizing filter characteristic using the method of one of the above-described embodiments for a predetermined loudspeaker.

Determining this maximum amplification or gain allows increasing the maximum amplification as set by the manufacturer, for example.

Furthermore, the invention provides a computer program product comprising one or more computer readable media having computer-executable instructions for performing the steps of the above-described methods.

Furthermore, an indoor communication system for a vehicular cabin is provided, comprising:

a signal generator configured to generate a predetermined test signal,

at least one loudspeaker connected to the signal generator for emitting the predetermined test signal,

at least one microphone array for receiving the emitted test signal,

a beamformer for each microphone array for beamforming the signals emanating from a microphone array to provide a received test signal,

a signal processing means connected to the signal generator and to the at least one microphone array, wherein the signal processing means is configured to automatically determine a transfer function in the frequency domain based on the test signal and the received test signal and to automatically determine an equalizing filter characteristic based on the transfer function. The at least one loudspeaker is associated with the at least one microphone array and a corresponding speaker position. Further, the signal processing means is configured to automatically determine an extremum, in particular, a maximum of the magnitude of the transfer function and to automatically determine a maximum amplification as

$$Gain_{max} = 1 / \max\{| H(e^{j\Omega}) G(e^{j\Omega}) |\}$$

with $H(e^{j\Omega})$ being the transfer function and $G(e^{j\Omega})$ being the frequency response of the equalizing filter.

These indoor communication systems allow to use components that are often already present in a vehicular cabin such as loudspeakers and microphone or microphone arrays, for example, for use in a handsfree telephone system. Then, in the case of microphone arrays, each microphone array is connected to the signal processing means via a beamformer. It is to be understood that microphones and microphone arrays can both be used in a vehicular cabin. For example, microphone arrays can be provided for the front passengers whereas for back passengers, only single microphones are present.

The indoor communication system can comprise at least two loudspeakers and the signal generator can be connected to the at least two loudspeakers in such a way that the test signal can be separately emitted by each loudspeaker. This allows to separately perform the previously described methods for each loudspeaker independently of the other loudspeakers.

The signal generator can be configured to emit binary white noise or colored noise, particularly pink noise.

The signal processing means of the indoor communication system can be configured to process the test signal and the received test signal in the time domain, in particular, using an adaptive filter or using an estimation method based on a periodogram, an autocorrelation function or a cross-correlation function. In particular, the signal processing means can comprise an NLMS (normalized least means squared) adaptive filter.

As an alternative to a signal generator configured to emit broadband noise, the signal generator can be configured to emit band pass noise with variable center frequency.

In this case, the signal processing means can be configured to determine the square root of the quotient of the short time power spectrum of the received test signal and the short time power spectrum of the test signal for each band pass noise.

The signal processing means can be configured to determine a global extremum of the magnitude of the transfer function.

Then, the signal processing means can be configured to further determine a local extremum for which the magnitude of the transfer function differs not more than a predetermined amount from the magnitude of the transfer function and a global extremum. The signal processing means can be configured to automatically attenuate a predetermined frequency band being centered at a determined maximum and/or to amplify a predetermined frequency band being centered at a determined minimum.

In such a case, the signal processing means can comprise a nonlinear phase filter for attenuating a predetermined frequency band.

Further features and advantages of the invention will be described in the following with respect to the examples and figures in which:

Fig. 1     is a schematic illustration of an example of an indoor communication system of a vehicular cabin;

Fig. 2     schematically illustrates an example of an indoor communication system allowing determining an equalizing filter characteristic;

Fig. 3     is a flow diagram of an example of a method for automatically determining an equalizing filter characteristic;

Fig. 4     illustrates an example of how to attenuate a possible feedback frequency; and

Fig. 5     is a flow diagram of an example of a method for modifying a maximum amplification.

Where the present invention is described with reference to the embodiments as illustrated in the following detailed description as well as in the drawings, it should be understood that the detailed description and the drawings are not intended to limit the present invention to the particular illustrative embodiments disclosed, but rather the described illustrated embodiments merely exemplify the various aspects of the present invention, the scope of which is defined by the appended claims.

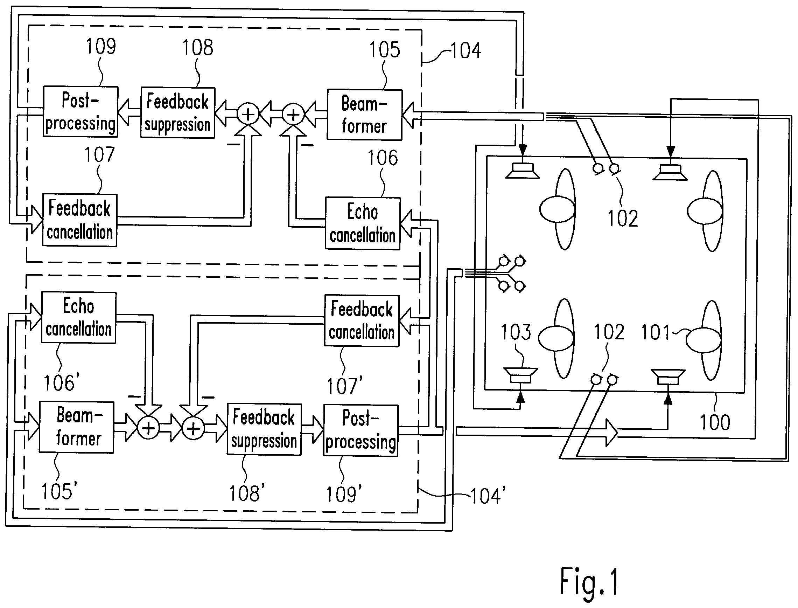

An overview of a system for indoor communication in a vehicular cabin 100 is shown in Fig. 1. The vehicular cabin 100 comprises four passengers' seats (not shown) and four passengers 101. With each passenger, a microphone array comprising two microphones 102 and a loudspeaker 103 are associated. For the front passengers, the microphone arrays are arranged in the center between the passengers. They can be provided at the car roof, for example. At the rear seats, the microphone arrays are provided at the left and right side of the passengers, respectively, for example, in the car door. Each loudspeaker can comprise a high-frequency and a low-frequency unit, for example.

The microphone arrays record signals. The signals emanating from the microphone arrays enter a digital signal processing means 104 and 104'. In the example shown in Fig. 1, a first signal processing means 104 is responsible for processing the signals emanating from the microphones associated with the rear passengers and a second digital signal processing means 104' is associated with the signals emanating from the microphones associated with the front passengers. However, this is only a matter of choice and the signals emanating from the different microphone arrays and also the signals output by the different loudspeakers can be processed in different combinations.

The signals emanating from the microphone arrays, first of all, are processed by an analog/digital converter (not shown). This is followed by a beamformer 105 and 105'. The beamformers serve to obtain information on the temporal signal behavior and also spatial information about the signal sources of both wanted (e.g. passengers) and noise signal sources (e.g. car radio loudspeakers). Different types of beamformers (e.g., adaptive beamformers) can be used for the present invention.

Independent of the method according to the invention, additional feedback effects can also be avoided during operation of the indoor communication system. For this, echo and feedback components are subtracted from the signal via adaptive echo cancellation 106 and 106' and feedback cancellation 107 and 107'. Adaptive notch filters 108 and 108' can detect potential feedback frequencies and attenuate these.

Based on the temporal and the spatial information from the beamformer, attenuators are controlled such that, for example, only the loudest speaker is switched through. However such a corresponding component is not shown explicitly in Fig. 1. A post processing 109 and 109' can apply a boundary characteristic. The output signals of the digital signal processing means 104 and 104' are fed, first of all, to corresponding loudspeakers 103. In the example shown in Fig. 1, signals emanating from rear microphone arrays can only be output by front loudspeakers and vice versa. This is, however, not a necessary restriction, the system can also be configured, for example, such that the processed signals can be output by all loudspeakers except the loudspeakers corresponding to the microphone array of the input signals.

Furthermore, the processed signals are also fed to feedback cancellation 107 and 107' of the same digital signal processing means and also to echo cancellation means 106 and 106' of the other digital signal processing means.

As an alternative to the example shown in Fig. 1, it is also possible to replace some or all of the microphone arrays by single microphones. For example, directional microphones can be used instead of microphone arrays.

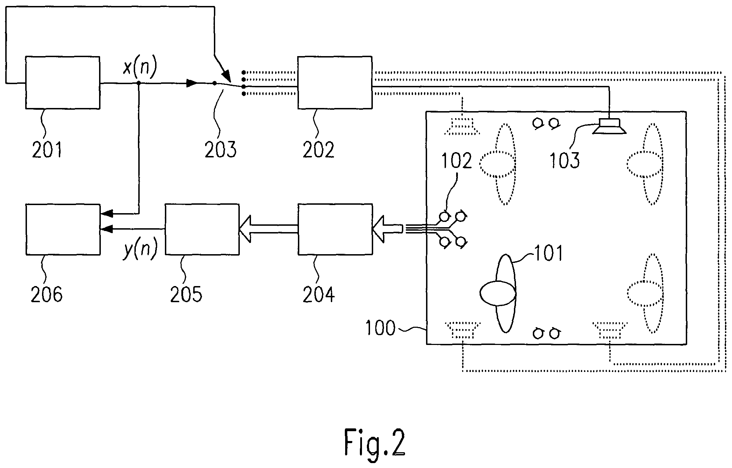

An example of an indoor communication system and the method for operating the same is illustrated in Fig. 2. Again, a vehicular cabin 100 and a passenger 101 (and possible other passengers) are shown. In the illustrated example, the method for determining an equalizing filter characteristic is performed for only one active loudspeaker 103; the other loudspeakers that are not active are indicated by dashed lines.

A signal generator 201 is present for providing a test signal $x(n)$. Such a test signal is passed through a D/A converter and amplifier 202. Each loudspeaker can be addressed independently of the other loudspeakers, which is indicated by a switch 203. The test signal emitted by loudspeaker 103 is recorded by the microphone arrays 102. In particular, the test signal can be recorded by all microphone arrays simultaneously; however, it is also possible to successively record the signal by the different microphone arrays. The signals emanating from the microphone arrays are passed through an A/D converter and amplifier 204. After that, beamforming is performed in beamformer 205 yielding a beamformed signal $y(n)$. This signal is passed to signal processing means 206 that is not only connected to the microphone array but also to signal generator 201 to receive the test signal $x(n)$.

The signal processing means 206 that is responsible for determining an equalizing filter characteristic can be part of signal processing means 104 or 104' of Fig. 1. However, it is also possible to provide this signal processing means 206 as a separate unit. This is particularly useful for later equipping a vehicle that already has an indoor communication system mounted therein.

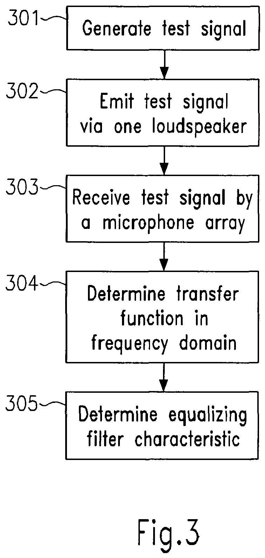

The course of action of an example of a method for automatically determining an equalizing filter characteristic is illustrated in Fig. 3. In a first step 301, a test signal is generated. In principle, different test signals are possible. In particular, binary white noise can be used as test signal. This is an advantageous choice since all frequencies are present and uniformly distributed. However, since, in most cases, passengers are sitting in the vehicular cabin, colored noise can also be used. For example, pink noise can be generated. As long as all frequencies are sufficiently activated, other colored noises can also be used.

Instead of broadband signals, it is also possible to use narrowband test signals such as band pass noise with variable center frequency. In this case, all frequency ranges should be activated successively.

In the following step 302, the test signal is emitted by one of the loudspeakers. This corresponds to the configuration of Fig. 2. However, two or more loudspeakers can alternatively emit the test signal in parallel.

Then, in step 303, the test signal is received by a microphone array, particularly by all microphone arrays. The signal emanating from the microphone array and having passed through the beamformer is fed to a signal processing means where the test signal and the received test signal are used to automatically determine a transfer function in the frequency domain in step 304. In the case of broadband test signals, the transmission behavior can be determined in the time domain, for example, using an adaptive filter. For this, the normalized least mean square (NLMS) algorithm with small increments can be adopted. After that, the impulse response is to be transformed to the frequency domain to obtain the transfer function $H(e^{j\Omega})$. Instead of adaptive filters, one can also use estimation methods based on periodograms or on autocorrelation or cross-correlation functions.

If narrowband test signals are adopted, the transfer function can be determined as the square root of the quotient of the short time power spectra

$$\sqrt{\overline{\sigma_y^2(n)}/\overline{\sigma_x^2(n)}}\,.$$

Both short time power spectra are determined for each band pass noise so as to obtain sampling points at the center frequencies of the band pass signals.

In the subsequent step 305, an equalizing filter characteristic is determined such that an equalizing filter for microphone array/loudspeaker pair is obtained resulting in a reduced feedback risk for this pair of components.

By performing these steps for a specific loudspeaker and simultaneously for all microphone arrays, equalizing filters are obtained for each of these pairs. Then, the steps are to be repeated with another loudspeaker until the method was performed for all loudspeakers being present in the vehicular cabin.

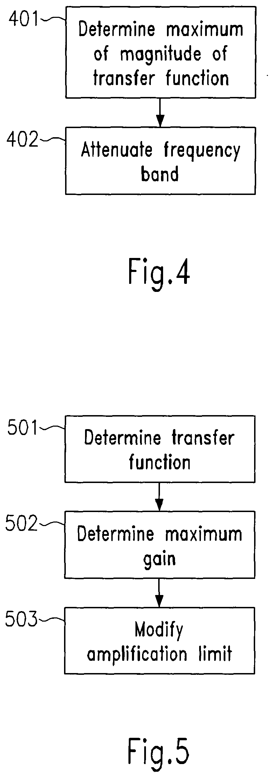

Fig. 4 illustrates an example of how to determine (at least parts of) an equalizing filter characteristic in step 305 of Fig. 3. This is particularly useful, when determining the transfer function using adaptive filters as described above. According to this example, one or several maxima of the transfer function $H(e^{j\Omega})$ are determined in step 401, in other words, a maximum frequency $\Omega_{max}$

$$\left| H(e^{j\Omega}) \right|_{\Omega=\Omega_{max}} \rightarrow \max$$

is determined. The number of frequencies determined in this way, particularly depends on the design principle of the equalization filters. For example, 3 - 5 frequency values can be determined if these frequencies are sufficiently separated. If this is not the case, one can also determine more than 5 frequency values.

When using narrowband test noise, the frequencies $\Omega_{max}$ or the band pass ranges with the largest quotient are determined based on the above described short time power spectra.

Then, for a particular loudspeaker/microphone array pair, possible feedback frequencies have been determined.

After having determined a possible feedback frequency in step 401, an attenuation is provided for one or several frequency bands (depending on the number of possible feedback frequencies) in step 402. In this step, attenuations are applied in small bands around the determined frequencies $\Omega_{max}$. In particular, attenuations of some dB can be inserted whereas the remaining frequency ranges are not attenuated.

Corresponding steps can be performed for amplifying minima of the transfer function. In such a case, minimum frequencies are to be determined and corresponding amplifications are to be applied. In this way, an output signal is considered louder by the listener.

Since the transfer functions of different loudspeaker/microphone array pairs are usually different, an additional positive effect can be achieved when using nonlinear phase equalizing filters. By insertion of small delay differences when playing mono signals via several loudspeakers, the subject quality impression can be increased (see e.g. M. Schroeder, Computer Speech - Recognition, Compression, Synthesis, Springer 1999). This effect can be considered when determining the equalization filters.

Fig. 5 illustrates a modification of the maximum amplification (stability limit) of an indoor communication system after having determined the transfer function in step 501 as described above. The maximum gain (amplification) is determined in step 502

$$Gain_{max} = 1 / \max\{| H(e^{j\Omega}) G(e^{j\Omega}) |\}$$

with $H(e^{j\Omega})$ the transfer function and $H(e^{j\Omega})$ the frequency response of the corresponding equalizing filter. This reciprocal value can be determined for each loudspeaker/microphone array pair.

Knowing about this stability limit, the maximum amplification can be modified accordingly in step 503. This enables to operate the indoor communication system near the stability limit, which is particularly useful in the case of large ambient noise. Due to the determination of the transfer function, this stability limit can be individually determined for each vehicle (and each loudspeaker and microphone or microphone array mounted therein) and can be used to correct (increase) the maximum amplification as originally set by the manufacturer. In this way, the quality of indoor communication systems can further be improved.

Since equalizing filters are used for reproducing signals of the indoor communication system, the equalizing filters should be placed before the mixing matrices of the audio amplifiers. In this case, the equalizing filters do not modify the sound of other audio sources of the vehicle.

In addition, the previously described methods can also be used to improve the audio output of other audio components such as handsfree systems or speech recognition. If it is detected by the method that the so-called center loudspeaker being located at the vicinity of the front microphones creates larger microphone signals than the other loudspeakers, its output power can be reduced correspondingly. An overdriving of the microphones due to the audio output can be avoided in this way, which increases the performance of the handsfree system or the speech recognition system.

Further modifications and variations of the present invention will be apparent to those skilled in the art in view of this description. Accordingly, the description is to be construed as illustrative only and is for the purpose of teaching those skilled in the art the general manner of carrying out the present invention. It is to be understood that the forms of the invention as shown and described herein are to be taken as the presently preferred embodiments.

**Claims**

1. Method for automatically determining an equalizing filter characteristic for an indoor communication system of a vehicular cabin (100), the indoor communication system comprising at least one loudspeaker (103) and at least one microphone array connected to a beamformer (105; 105'), the at least one loudspeaker (103) associated with the at least one microphone array and a corresponding speaker position, comprising the steps of:

   a) emitting a predetermined test signal by a loudspeaker, in particular, by one loudspeaker, of the indoor communication system,
   b) receiving the test signal by a microphone array of the indoor communication system and beamforming the signals emanating from the microphone array using the beamformer connected thereto to obtain a received test signal,
   c) automatically determining a transfer function in the frequency domain based on the test signal and the received test signal,
   **characterised in that** the method further comprises the steps of
   d) automatically determining an equalizing filter characteristic based on determining an extremum, in particular, a maximum, of the magnitude of the the transfer function; and
   e) automatically determining a maximum amplification value as

$$Gain_{\max} = 1/\max\{|H(e^{j\Omega})G(e^{j\Omega})|\}.$$

   with $H(e^{j\Omega})$ being the transfer function and $G(e^{j\Omega})$ being the frequency response of the equalizing filter.

2. Method according to claim 1, wherein step a) comprises emitting binary white noise or colored noise, particularly, pink noise.

3. Method according to one of the preceding claims, wherein step c) comprises processing the test signal and the received test signal in the time domain, in particular, using an adaptive filter or using an estimation method based on a periodogram, an autocorrelation function or a cross-correlation function.

4. Method according to claim 1, wherein step a) comprises emitting band pass noise with variable center frequency.

5. Method according to claim 4, wherein step c) comprises determining the square root of the quotient of the short time power spectrum of the received test signal and the short time power spectrum of the test signal for each band pass noise.

6. Method according to claim 1, wherein step d) comprises determining a global extremum of the magnitude of the transfer function.

7. Method according to claim 6, wherein step d) further comprises determining a local extremum for which the magnitude of the transfer function differs not more than a predetermined amount from the magnitude of the transfer function at a global extremum.

8. Method according to one of the claims 1 and 7, wherein step d) further comprises providing an attenuation of a predetermined frequency band being centered at a determined maximum and/or providing an amplification of a predetermined frequency band being centered at a determined minimum.

9. Method according to claim 8, wherein an attenuation is provided using a nonlinear phase filter.

10. Method for automatically determining a maximum amplification value of an indoor communication system of a vehicular cabin, comprising:
    automatically determining an equalizing filter characteristic using the method of one of the claims 1 - 9 for a predetermined loudspeaker.

11. Computer program product, comprising one or more computer readable media having computer-executable instructions for performing the steps of the method of one of the preceding claims.

12. Indoor communication system for a vehicular cabin (100), comprising

a signal generator configured to generate a predetermined test signal,
at least one loudspeaker (103) connected to the signal generator for emitting a predetermined test signal,
at least one microphone array for receiving the emitted test signal,
a beamformer (105; 105') for each microphone array for beamforming the signals emanating from a microphone array to provide a received test signal,
a signal processing means (104; 104') connected to the signal generator and to the at least one microphone array, wherein the signal processing means (104; 104') is configured to automatically determine a transfer function in the frequency domain based on the test signal and the received test signal and to automatically determine an equalizing filter characteristic based on the transfer function,
wherein the at least one loudspeaker (103) is associated with the at least one microphone array and a corresponding speaker position:

**characterised in that** the indoor communication system further comprises
wherein the signal processing means (104; 104') is configured to automatically determine an extremum, in particular, a maximum, of the magnitude of the transfer function and to automatically determine a maximum amplification as

$$Gain_{\max} = 1/\max\{|\, H(e^{j\Omega}) G(e^{j\Omega})\,|\}$$

with $H(e^{j\Omega})$ being the transfer function and $G(e^{j\Omega})$ being the frequency response of the equalizing filter.

13. Indoor communication system according to claim 12, comprising at least two loudspeakers and wherein the signal generator is connected to the at least two loudspeakers in such a way that the test signal can be separately emitted by each loudspeaker.

14. Indoor communication system according to one of the claims 12 - 13, wherein the signal generator is configured to emit binary white noise or colored noise, particularly, pink noise.

15. Indoor communication system according to one of the claims 12 - 14, wherein the signal processing means is configured to process the test signal and the received test signal in the time domain, in particular, using an adaptive filter or using an estimation method based on a periodogram, an autocorrelation function or a cross-correlation function.

16. Indoor communication system according to one of the claims 12 - 15, wherein the signal generator is configured to emit band pass noise with variable center frequency.

17. Indoor communication system according to claim 16, wherein the signal processing means is configured to determine the square root of the quotient of the short time power spectrum of the received test signal and the short time power spectrum of the test signal for each band pass noise.

18. Indoor communication system according to one of the claims 12, wherein the signal processing means is configured to determine a global extremum of the magnitude of the transfer function.

19. Indoor communication system according to claim 18, wherein the signal processing means is configured to further determine a local extremum for which the magnitude of the transfer function differs not more than a predetermined amount from the magnitude of the transfer function at a global extremum.

20. Indoor communication system according to one of the claims 12 - 19, wherein the signal processing means is configured to automatically attenuate a predetermined frequency band being centered at a determined maximum and/or to amplify a predetermined frequency band being centered at a determined minimum.

21. Indoor communication system according to claim 20, wherein the signal processing means comprises a nonlinear phase filter for attenuating a predetermined frequency band.

**Patentansprüche**

1. Verfahren zum automatischen Bestimmen einer Entzerrungsfiltereigenschaft für ein Innenraum-Nachrichtenübertragungssystem einer Fahrzeugkabine (100), wobei das Innenraum-Nachrichtenübertragungssystem mindestens einen Lautsprecher (103) und mindestens eine Mikrofonanordnung, die mit einer Strahlenbildungsvorrichtung (105; 105') verbunden ist, umfasst, wobei der mindestens eine Lautsprecher (103) der mindestens einen Mikrofonanordnung und einer entsprechenden Lautsprecherposition zugeordnet ist, die folgenden Schritte umfassend:

   a) Ausgeben eines vorbestimmten Testsignals durch einen Lautsprecher, insbesondere durch einen Lautsprecher des Innenraum-Nachrichtenübertragungssystems,
   b) Empfangen des Testsignals durch eine Mikrofonanordnung des Innenraum-Nachrichtenübertragungssystems und Strahlenbilden des Signals, das von der Mikrofonanordnung ausgeht, unter Verwendung der Strahlenbildungsvorrichtung, die damit verbunden ist, um ein empfangenes Testsignal zu erhalten,
   c) automatisches Bestimmen einer Übertragungsfunktion in dem Frequenzbereich auf Grundlage des Testsignals und des empfangenen Testsignals,

   **dadurch gekennzeichnet, dass** das Verfahren ferner die folgenden Schritte umfasst:

   d) automatisches Bestimmen einer Entzerrungsfiltereigenschaft auf Grundlage eines Bestimmens eines Extremwerts, insbesondere eines Maximalwerts des Betrags der Übertragungsfunktion; und
   e) automatisches Bestimmen eines maximalen Verstärkungswerts als

   $$Zunahme_{max} = \ 1/\max\{|H(e^{j\Omega})\, G(e^{j\Omega})|\},$$

   wobei $H(e^{j\Omega})$ die Übertragungsfunktion und $G(e^{j\Omega})$ die Frequenzantwort des Entzerrungsfilters ist.

2. Verfahren nach Anspruch 1, wobei Schritt a) das Ausgeben eines binären weißen Rauschens oder eines farbigen Rauschens, insbesondere eines rosa Rauschens, umfasst.

3. Verfahren nach einem der vorhergehenden Ansprüche, wobei Schritt c) das Verarbeiten des Testsignals und des empfangenen Testsignals in dem Zeitbereich umfasst, insbesondere unter Verwendung eines adaptiven Filters oder unter Verwendung eines Schätzverfahrens auf Grundlage eines Periodogramms, einer Autokorrelationsfunktion oder einer Kreuzkorrelationsfunktion.

4. Verfahren nach Anspruch 1, wobei Schritt a) das Ausgeben eines Bandpassrauschens mit variabler Mittelfrequenz umfasst.

5. Verfahren nach Anspruch 4, wobei Schritt c) ein Bestimmen der Quadratwurzel des Quotienten des Kurzzeitleistungsspektrums des empfangenen Testsignals und des Kurzzeitleistungsspektrums des Testsignals für jedes Bandpassrauschen umfasst.

6. Verfahren nach Anspruch 1, wobei Schritt d) ein Bestimmen eines globalen Extremwerts des Betrags der Übertragungsfunktion umfasst.

7. Verfahren nach Anspruch 6, wobei Schritt d) ferner ein Bestimmen eines lokalen Extremwerts umfasst, bei dem sich der Betrag der Übertragungsfunktion nicht mehr als ein vorbestimmtes Maß von dem Betrag der Übertragungsfunktion an einem globalen Extremwert unterscheidet.

8. Verfahren nach einem der Ansprüche 1 und 7, wobei Schritt d) ferner ein Bereitstellen einer Abschwächung eines vorbestimmten Frequenzbands, das an einem bestimmten Maximalwert zentriert ist, und/oder ein Bereitstellen einer Verstärkung eines vorbestimmen Frequenzbands, das an einem bestimmten Minimalwert zentriert ist, umfasst.

9. Verfahren nach Anspruch 8, wobei eine Abschwächung unter Verwendung eines nichtlinearen Phasenfilters bereitgestellt ist.

10. Verfahren zum automatischen Bestimmen eines maximalen Verstärkungswerts eines Innenraum-Nachrichtenübertragungssystems einer Fahrzeugkabine, Folgendes umfassend:
automatisches Bestimmen einer Entzerrungsfiltereigenschaft unter Verwendung des Verfahrens eines der Ansprüche 1-9 für einen vorbestimmten Lautsprecher.

11. Computerprogrammprodukt, das eines oder mehrere computerlesbare Medien umfasst, die computerlesbare Anweisungen zum Durchführen der Schritte des Verfahrens eines der vorhergehenden Ansprüche aufweisen.

12. Innenraum-Nachrichtenübertragungssystem für eine Fahrzeugkabine (100), Folgendes umfassend:

eine Signalerzeugungsvorrichtung, die dazu konfiguriert ist, ein vorbestimmtes Testsignal zu erzeugen,
mindestens einen Lautsprecher (103), der mit der Signalerzeugungsvorrichtung zum Ausgeben eines vorbestimmten Testsignals verbunden ist,
mindestens eine Mikrofonanordnung zum Empfangen des ausgegebenen Testsignals,
eine Strahlenbildungsvorrichtung (105; 105') für jede Mikrofonanordnung zum Strahlenbilden des Signals, das von einer Mikrofonanordnung ausgeht, um ein empfangenes Testsignal bereitzustellen,
ein Signalverarbeitungsmittel (104; 104'), das mit der Signalerzeugungsvorrichtung und mit der mindestens einen Mikrofonanordnung verbunden ist, wobei das Signalverarbeitungsmittel (104; 104') dazu konfiguriert ist, automatisch eine Übertragungsfunktion in dem Frequenzbereich auf Grundlage des Testsignals und des empfangenen Testsignals zu bestimmen, und automatisch eine Entzerrungsfiltereigenschaft auf Grundlage der Übertragungsfunktion zu bestimmen,
wobei der mindestens eine Lautsprecher (103) der mindestens einen Mikrofonanordnung und einer entsprechenden Lautsprecherposition zugeordnet ist;
**dadurch gekennzeichnet, dass** das Innenraum-Nachrichtenübertragungssystem ferner Folgendes umfasst:
wobei das Signalverarbeitungsmittel (104; 104') dazu konfiguriert ist, einen Extremwert, insbesondere einen Maximalwert, des Betrags der Übertragungsfunktion automatisch zu bestimmen und eine maximale Verstärkung automatisch als

$$Zunahme_{max} = 1/\max\{|H(e^{j\Omega})\, G(e^{j\Omega})|\}$$

zu bestimmen, wobei $H(e^{j\Omega})$ die Übertragungsfunktion und $G(e^{j\Omega})$ die Frequenzantwort des Entzerrungsfilters ist.

13. Innenraum-Nachrichtenübertragungssystem nach Anspruch 12, das mindestens zwei Lautsprecher umfasst und wobei die Signalerzeugungsvorrichtung mit den mindestens zwei Lautsprechern derart verbunden ist, dass das Testsignal von jedem Lautsprecher separat ausgegeben werden kann.

14. Innenraum-Nachrichtenübertragungssystem nach einem der Ansprüche 12-13, wobei die Signalerzeugungsvorrichtung dazu konfiguriert ist, ein binäres weißes Rauschen oder ein farbiges Rauschen, insbesondere ein rosa Rauschen, auszugeben.

15. Innenraum-Nachrichtenübertragungssystem nach einem der Ansprüche 12-14, wobei das Signalverarbeitungsmittel dazu konfiguriert ist, das Testsignal und das empfangene Testsignal in dem Zeitbereich zu verarbeiten, insbesondere unter Verwendung eines adaptiven Filters oder unter Verwendung eines Schätzverfahrens auf Grundlage eines Periodogramms, einer Autorkorrelationsfunktion oder einer Kreuzkorrelationsfunktion.

16. Innenraum-Nachrichtenübertragungssystem nach einem der Ansprüche 12-15, wobei die Signalerzeugungsvorrichtung dazu konfiguriert ist, ein Bandpassrauschen mit variabler Mittelfrequenz auszugeben.

17. Innenraum-Nachrichtenübertragungssystem nach Anspruch 16, wobei das Signalverarbeitungsmittel dazu konfiguriert ist, die Quadratwurzel des Quotienten des Kurzzeitleistungsspektrums des empfangenen Testsignals und das Kurzzeitleistungsspektrum des Testsignals für jedes Bandpassrauschen zu bestimmen.

18. Innenraum-Nachrichtenübertragungssystem nach einem der Ansprüche 12, wobei das Signalverarbeitungsmittel dazu konfiguriert ist, einen globalen Extremwert des Betrags der Übertragungsfunktion zu bestimmen.

19. Innenraum-Nachrichtenübertragungssystem nach Anspruch 18, wobei das Signalverarbeitungsmittel dazu konfiguriert ist, ferner einen lokalen Extremwert zu bestimmen, bei dem sich der Betrag der Übertragungsfunktion nicht mehr als ein vorbestimmtes Maß von dem Betrag der Übertragungsfunktion an einem globalen Extremwert unterscheidet.

20. Innenraum-Nachrichtenübertragungssystem nach einem der Ansprüche 12-19, wobei das Signalverarbeitungsmittel dazu konfiguriert ist, ein vorbestimmtes Frequenzband, das an einem bestimmen Maximalwert zentriert ist, abzuschwächen und/oder ein vorbestimmtes Frequenzband, das an einem bestimmten Minimalwert zentriert ist, zu verstärken.

21. Innenraum-Nachrichtenübertragungssystem nach Anspruch 20, wobei das Signalverarbeitungsmittel einen nichtlinearen Phasenfilter zum Abschwächen eines vorbestimmten Frequenzbands umfasst.

**Revendications**

1. Procédé de détermination automatique d'une caractéristique de filtre d'égalisation pour un système de communication d'intérieur d'une cabine de véhicule (100), le système de communication d'intérieur comprenant au moins un haut-parleur (103) et au moins un réseau de microphones connecté à un dispositif de formation de faisceau (105 ; 105'), l'au moins un haut-parleur (103) associé à l'au moins un réseau de microphones et à une position de haut-parleur correspondante, comprenant les étapes comprenant :

   a) l'émission d'un signal de test prédéterminé par un haut-parleur, en particulier par un haut-parleur du système de communication d'intérieur,
   b) la réception du signal de test par un réseau de microphones du système de communication d'intérieur et la formation sous forme de faisceau des signaux provenant du réseau de microphones en utilisant le dispositif de formation de faisceau connecté à celui-ci pour obtenir un signal de test reçu,
   c) la détermination automatique d'une fonction de transfert dans le domaine fréquentiel sur la base du signal de test et du signal de test reçu,

   **caractérisé en ce que** le procédé comprend en outre les étapes suivantes :

   d) déterminer automatiquement une caractéristique de filtre d'égalisation sur la base de la détermination d'un extremum, en particulier d'un maximum de l'amplitude de la fonction de transfert ; et
   e) déterminer automatiquement une valeur d'amplification maximale égale à $Gain_{max} = 1/max\{|H(e^{j\,\Omega})G(e^{j\,\Omega})|\}$ $H(e^{j\,\Omega})$ étant la fonction de transfert et $G(e^{j\,\Omega})$ la réponse en fréquence du filtre d'égalisation.

2. Procédé selon la revendication 1, dans lequel l'étape a) comprend l'émission d'un bruit binaire blanc ou d'un bruit coloré, notamment d'un bruit rose.

3. Procédé selon l'une des revendications précédentes, dans lequel l'étape c) comprend le traitement du signal de test et du signal de test reçu dans le domaine temporel, notamment à l'aide d'un filtre adaptatif ou d'un procédé d'estimation sur la base d'un périodogramme, d'une fonction d'autocorrélation ou d'une fonction de corrélation croisée.

4. Procédé selon la revendication 1, dans lequel l'étape a) comprend l'émission d'un bruit de bande passante avec une fréquence centrale variable.

5. Procédé selon la revendication 4, dans lequel l'étape c) comprend la détermination de la racine carrée du quotient du spectre de puissance à temps court du signal de test reçu et du spectre de puissance à temps court du signal de test pour chaque bruit de bande passante.

6. Procédé selon la revendication 1, dans lequel l'étape d) comprend la détermination d'un extremum global de l'amplitude de la fonction de transfert.

7. Procédé selon la revendication 6, dans lequel l'étape d) comprend en outre la détermination d'un extremum local pour lequel l'amplitude de la fonction de transfert ne diffère pas plus d'une quantité prédéterminée de l'amplitude de la fonction de transfert à un extremum global.

8. Procédé selon l'une des revendications 1 et 7, dans lequel l'étape d) comprend en outre la fourniture d'une atténuation d'une bande de fréquence prédéterminée centrée sur un maximum déterminé et/ou la fourniture d'une amplification d'une bande de fréquence prédéterminée centrée sur un minimum déterminé.

9. Procédé selon la revendication 8, dans lequel une atténuation est fournie en utilisant un filtre de phase non linéaire.

10. Procédé pour déterminer automatiquement une valeur d'amplification maximale d'un système de communication d'intérieur d'une cabine de véhicule, comprenant :
la détermination automatique d'une caractéristique de filtre d'égalisation en utilisant le procédé selon l'une des revendications 1 à 9 pour un haut-parleur prédéterminé.

11. Programme d'ordinateur, comprenant un ou plusieurs supports lisibles par ordinateur ayant des instructions exécutables par un ordinateur pour effectuer les étapes du procédé de l'une des revendications précédentes.

12. Système de communication d'intérieur pour une cabine de véhicule (100), comprenant
un générateur de signal configuré pour générer un signal de test prédéterminé,
au moins un haut-parleur (103) connecté au générateur de signal pour émettre un signal de test prédéterminé,
au moins un réseau de microphones destiné à recevoir le signal de test émis,
un dispositif de formation de faisceau (105 ; 105') pour chaque réseau de microphones afin de former sous forme de faisceau les signaux provenant d'un réseau de microphones pour fournir un signal de test reçu,
un moyen de traitement de signal (104 ; 104') connecté au générateur de signal et à l'au moins un réseau de microphones, le moyen de traitement de signal (104 ; 104') étant configuré pour déterminer automatiquement une fonction de transfert dans le domaine fréquentiel sur la base du signal de test et du signal de test reçu et pour déterminer automatiquement une caractéristique de filtre d'égalisation sur la base de la fonction de transfert, dans lequel l'au moins un haut-parleur (103) est associé à l'au moins un réseau de microphones et à une position de haut-parleur correspondante ;
**caractérisé en ce que** le système de communication d'intérieur comprend en outre
dans lequel le moyen de traitement de signal (104 ; 104') est configuré pour déterminer automatiquement un extremum, en particulier, un maximum, de l'amplitude de la fonction de transfert et pour déterminer automatiquement une amplification maximale égale à

$$Gain_{max} = 1 / max\left\{\left|H\left(e^{j\,\Omega}\right)G(e^{j\,\Omega})\right|\right\}$$

$H(e^{j\,\Omega})$ comme étant la fonction de transfert et $G(e^{j\Omega})$ la réponse en fréquence du filtre d'égalisation.

13. Système de communication d'intérieur selon la revendication 12, comprenant au moins deux haut-parleurs et dans lequel le générateur de signal est connecté à l'au moins deux haut-parleurs de sorte que le signal de test puisse être émis séparément par chaque haut-parleur.

14. Système de communication d'intérieur selon l'une des revendications 12 à 13, dans lequel le générateur de signal est configuré pour émettre un bruit binaire blanc ou un bruit coloré, notamment un bruit rose.

15. Système de communication d'intérieur selon l'une des revendications 12 à 14, dans lequel le moyen de traitement de signal est configuré pour traiter le signal de test et le signal de test reçu dans le domaine temporel, notamment à l'aide d'un filtre adaptatif ou d'un procédé d'estimation sur la base d'un périodogramme, d'une fonction d'autocorrélation ou d'une fonction de corrélation croisée.

16. Système de communication d'intérieur selon l'une des revendications 12 à 15, dans lequel le générateur de signal est configuré pour émettre un bruit de bande passante avec une fréquence centrale variable.

17. Système de communication d'intérieur selon la revendication 16, dans lequel le moyen de traitement de signal est configuré pour déterminer la racine carrée du quotient du spectre de puissance à temps court du signal de test reçu et le spectre de puissance à temps court du signal de test pour chaque bruit de bande passante.

18. Système de communication d'intérieur selon la revendication 12, dans lequel le moyen de traitement de signal est configuré pour déterminer un extremum global de l'amplitude de la fonction de transfert.

**19.** Système de communication d'intérieur selon la revendication 18, dans lequel le moyen de traitement de signal est configuré pour déterminer en outre un extremum local pour lequel l'amplitude de la fonction de transfert ne diffère pas plus d'une quantité prédéterminée de l'amplitude de la fonction de transfert à un extremum global.

**20.** Procédé selon l'une des revendications 12 à 19, dans lequel le moyen de traitement de signal est configuré pour atténuer automatiquement une bande de fréquence prédéterminée centrée à un maximum déterminé et/ou pour amplifier une bande de fréquence prédéterminée centrée à un minimum déterminé.

**21.** Système de communication d'intérieur selon la revendication 20, dans lequel le moyen de traitement de signal comprend un filtre de phase non linéaire pour atténuer une bande de fréquence prédéterminée.

Fig.1

EP 1 591 995 B1

Fig.2

301 — Generate test signal

302 — Emit test signal via one loudspeaker

303 — Receive test signal by a microphone array

304 — Determine transfer function in frequency domain

305 — Determine equalizing filter characteristic

Fig.3

401 — Determine maximum of magnitude of transfer function

402 — Attenuate frequency band

Fig.4

501 — Determine transfer function

502 — Determine maximum gain

503 — Modify amplification limit

Fig.5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4739513 A
- EP 0898364 A
- US 5386478 A
- US 5170433 A
- US 6674865 B1
- EP 1077584 A2
- WO 03010996 A2
- JP 2050090856 A
- JP 4047787 A

**Non-patent literature cited in the description**

- **S. HAYKIN ; B. WIDROW.** Least-Mean-Square Adaptive Filtering. John Wiley and Sons, 2003
- **M. SCHROEDER.** Computer Speech - Recognition, Compression, Synthesis. Springer, 1999